# EUROPÄISCHE PATENTANMELDUNG

(11) **EP 1 510 797 A1**
(43) Veröffentlichungstag der Anmeldung: **02.03.2005**
(21) Anmeldenummer: 04020137.8
(22) Anmeldetag: 25.08.2004
(51) Int. Cl.: G01J 1/04, B60H 1/00

(54) **Sensorvorrichtung, insbesondere für Kraftfahrzeuge**

(30) Priorität: 29.08.2003 DE 10340346
(71) Anmelder: Hella KGaA Hueck & Co., 59552 Lippstadt (DE)
(72) Erfinder: Niemann, Thomas, Dipl.-Ing., 27753 Delmenhorst (DE); Henke, Thomas, Dipl.-Phys., 27616 Stubben (DE); Heilenkötter, Carsten, Dipl.-Ing., 28844 Weyhe (DE)
(74) Vertreter: Siekmann, Gunnar, Dipl.-Phys.

(57) **Zusammenfassung**

Bei einer Sensorvorrichtung zum Erzeugen eines elektrischen Ausgangssignals in Abhängigkeit von der Position einer Lichtquelle in Bezug auf die Sensorvorrichtung, wobei die Sensorvorrichtung einen dreidimensionalen Schaltungsträger mit mehreren aneinandergrenzenden, in verschiedene Richtungen ausgerichteten Flächen aufweist, auf denen mindestens zwei Sensoren angeordnet sind, sind zu beiden Seiten einer zentralen Fläche jeweils eine unter einem Winkel zu dieser Fläche ausgerichtete Fläche mit je einem IR-Photodetektor angeordnet, wobei die Flächen, auf denen die IR-Photodetektoren angeordnet sind, nicht unmittelbar aneinandergrenzen. Dadurch wird eine besonders gute, richtungsabhängige Detektion erreicht.

## Beschreibung

Die Erfindung betrifft eine Sensorvorrichtung zum Erzeugen eines elektrischen Ausgangssignals in Abhängigkeit von der Position einer Lichtquelle in Bezug auf die Sensorvorrichtung.

Eine Sensorvorrichtung der eingangs genannten Art ist aus der EP 0 350 866 B1 bekannt. Die bekannte Sensorvorrichtung weist einen Photodetektor auf, dem ein geometrisch speziell geformter Lichtmodulator zugeordnet ist. Zwischen dem Lichtmodulator und dem Photodetektor ist zudem ein Lichtdiffusor zum diffusen Ausbreiten bzw. zur Zerstreuung des einfallendes Lichtes angeordnet.

Der Erfindung liegt die Aufgabe zugrunde, eine Sensorvorrichtung der eingangs genannten Art zu schaffen, die besonders einfach und platzsparend aufgebaut ist.

Die Lösung dieser Aufgabe erfolgt mit einer Sensorvorrichtung mit den Merkmalen des Patentanspruchs 1. Vorteilhafte Weiterbildungen der Erfindung sind in den Unteransprüchen angegeben.

Bei einer Sensorvorrichtung zum Erzeugen eines elektrischen Ausgangssignals in Abhängigkeit von der Position einer Lichtquelle in Bezug auf die Sensorvorrichtung, wobei die Sensorvorrichtung einen dreidimensionalen Schaltungsträger mit mehreren aneinandergrenzenden, in verschiedene Richtungen ausgerichteten Flächen aufweist, auf denen mindestens zwei Sensoren angeordnet sind, ist es erfindungswesentlich, daß zu beiden Seiten einer zentralen, insbesondere nach vome ausgerichteten, Fläche jeweils eine unter einem Winkel zu dieser Fläche ausgerichtete Fläche mit je einem IR-Photodetektor angeordnet ist, wobei die Flächen, auf denen die IR-Photodetektoren angeordnet sind, nicht unmittelbar aneinandergrenzen. Bevorzugt ist auf der zentralen Fläche ein Photodetektor angeordnet, der als Photodetektor im Bereich des sichtbaren Lichtes ausgebildet ist. Eine solche Sensorvorrichtung wird insbesondere in Kraftfahrzeugen eingesetzt, um ein Signal in Abhängigkeit der Bestrahlungsstärke und Bestrahlungsrichtung zu erzeugen und um die Lichteinstrahlung, insbesondere die Richtung der Sonneneinstrahlung, feststellen zu können und dann in Abhängigkeit davon bestimmte Einrichtungen, beispielsweise eine Klimaanlage, entsprechend zu steuern. Durch die erfindungsgemäße Sensorvorrichtung können auf kleinem Raum zwei oder mehr Sensoren angeordnet werden, die insbesondere die seitliche Einstrahlung zuverlässig detektieren. Bei einer solchen Ausführungsform sind besonders gestaltete Lichtleiter nicht unbedingt notwendig. Zudem ist eine solche Sensorvorrichtung besonders klein herstellbar. Die Sensoren der Sensorvorrichtung können beispielsweise als Temperatursensoren oder bevorzugt als Photodetektoren ausgebildet sein. Mit derartigen Sensoren ist insbesondere die Steuerung einer Klimaanlage in Kraftfahrzeugen möglich.

Auf der zentralen, bevorzugt nach vorne in Fahrtrichtung des Kraftfahrzeuges ausgerichteten Fläche ist günstigerweise ein Photodetektor zur Detektion von sichtbarem Licht angeordnet. Diese Fläche und damit der darauf angeordnete Photodetektor ist etwas nach hinten gekippt angeordnet.

Bevorzugt weist die Sensorvorrichtung drei Sensoren, insbesondere drei Photodetektoren, auf, die in voneinander verschiedene Ausrichtungen angeordnet sind. Bevorzugt sind mindestens zwei Photodetektoren als IR-Photodetektoren ausgebildet. Derartige IR-Photodetektoren messen besonders gut die Wärmeeinstrahlung durch die Sonne. Diese zwei Photodetektoren sind bevorzugt zu den Seiten des Kraftfahrzeuges ausgerichtet, so daß feststellbar ist, ob die Sonneneinstrahlung eher von der rechten Fahrzeugseite oder eher von der linken Fahrzeugseite erfolgt und eine Klimaanlage entsprechend gesteuert werden kann. In einer bevorzugten Ausgestaltung der Erfindung ist einer der Photodetektoren als Photodetektor im Bereich des sichtbaren Lichtes ausgebildet. Ein solcher Photodetektor dient insbesondere der Simulation bzw. Erfassung des Lichtes, das auch das menschliche Auge wahrnimmt und ist daher besonders geeignet, Signale zu erzeugen, die für die Ein- oder Ausschaltung der Instrumenteninnenbeleuchtung und/oder des Fahrlichtes bzw. Abblendlichtes maßgeblich sind. Die Photodetektoren sind bevorzugt als Photodioden ausgebildet.

In einer besonders bevorzugten Ausgestaltung der Erfindung sind die Photodetektoren auf einem dreidimensionalen, spritzgegossenen Schaltungsträger angebracht. Insbesondere wird eine MID-Technik (Moulded Interconnect Devices) angewandt, wobei ein solches MID-Element aus einem dreidimensionalen Leiter, insbesondere einem Thermoplasten mit darauf angeordneten Leiterbahnen, besteht, wobei auf diesen Leiterbahnen insbesondere die beschriebenen Photodetektoren bzw. Photodioden angeordnet sind.

Die Sensorvorrichtung ist dabei bevorzugt so ausgestaltet, daß die Flächennormalen der Sensoren, insbesondere der IR-Photodetektoren, sich unter einem Winkel zwischen 90° und 180°, insbesondere einem Winkel zwischen 100° und 120°, schneiden. In einer anderen, besonders bevorzugten Ausgestaltung, schneiden sich die Flächennormalen der IR-Photodetektoren unter einem Winkel zwischen 60° und 80°, insbesondere unter einem Winkel von 70°. Dabei haben die Flächennormalen der IR-Photodetektoren mit einer Grundebene der Sensorvorrichtung in beiden Dimensionen von 90° abweichende Schnittwinkel. Der Winkel zwischen der Flächennormale der IR-Photodetektoren und der Grundebene liegt bevorzugt zwischen 35° und 55°, insbesondere bei 45°. Dies bedeutet insbesondere, daß die IR-Photodetektoren nicht nur auf zu den Seiten geneigten Flächen angeordnet sind, sondem diese Flächen auch gekantet oder gekippt sind. In Fahrtrichtung auf ein Auto bezogen wird die Sensorvorrichtung so eingesetzt, daß diese Flächen schräg nach vorne gekippt sind. Bevorzugt sind die IR-Photodetektoren symmetrisch zu dem zentral angeordneten Photodetektor für sichtbares Licht angeordnet.

In einer weiteren Ausgestaltung der Erfindung ist in die Sensorvorrichtung eine Anzeige für eine Diebstahlwarnanlage integriert. Diese ist bevorzugt parallel zu einer Grundebene der Photodetektorvorrichtung ausgerichtet. Dadurch ist diese Anzeige nach oben ausgerichtet und leicht wahrnehmbar.

In einer anderen bevorzugten Ausgestaltung weist die Sensorvorrichtung eine die Photodetektoren abdeckende lichtdurchlässige Abdeckung auf. Diese besteht bevorzugt aus einem lichtdurchlässigen Kunststoff und kann entsprechend der gewünschten Lichtcharakteristik farblos, weißlich, grünlich oder gräulich sein. In einer besonders bevorzugten Ausgestaltung der Erfindung weist die Abdeckung zusätzliche optische Elemente auf. Mit solchen optischen Elementen kann die schon durch die geometrische Ausrichtung der IR-Photodetektoren bewirkte Richtungssensitivität noch verstärkt werden. Bevorzugt sind die optischen Elemente als auf die Sensoren, insbesondere die IR-Photodetektoren, gerichtete lichtleitende Elemente, insbesondere röhrenartig, ausgebildet. Die lichtleitenden Elemente sind bevorzugt senkrecht auf die Photodetektoren ausgerichtet. Auf diese Weise ist eine besonders zuverlässige richtungsabhängige Auswertung möglich. Die lichtleitenden Elemente können dabei bevorzugt auch als Linsen und/oder als besonders gestaltete Wandabschnitte ausgebildet sein. Die besonders gestalteten Wandabschnitte können dabei durch eine Riffelung, eine spezielle Rauhigkeit oder durch eine andere, insbesondere dünnere, Wandstärke als besonderes lichtleitendes Element ausgebildet sein.

Nachfolgend wird die Erfindung anhand eines in der Zeichnung dargestellten Ausführungsbeispiels weiter erläutert. Im einzelnen zeigen die schematischen Darstellungen in:
- Fig. 1:: eine perspektivische Gesamtansicht einer erfindungsgemäßen Sensorvorrichtung;
- Fig. 2:: eine zweite perspektivische Ansicht einer erfindungsgemäßen Sensorvorrichtung, bei der ein Teil der die Sensorvorrichtung abdeckenden Abdeckung geschnitten dargestellt ist;
- Fig. 3:: eine perspektivische Ansicht eines dreidimensionalen Schaltungs trägers der erfindungsgemäßen Vorrichtung;
- Fig. 4:: eine Bodenansicht des spritzgegossenen Schaltungsträgers gemäß Fig. 3;
- Fig. 5:: eine perspektivische Ansicht eines Untergehäuses der Sensorvorrichtung;
- Fig. 6:: eine perspektivische Ansicht der Abdeckung der erfindungsgemäßen Sensorvorrichtung von unten;
- Fig. 7:: eine perspektivische Ansicht einer zweiten Ausführungsform eines dreidimensionalen Schaltungsträgers der erfindungsgemäßen Vorrichtung;
- Fig. 8:: eine andere perspektivische Ansicht des zweiten erfindungsgemäßen Schaltungsträgers gemäß Fig. 7; und
- Fig. 9:: eine dritte perspektivische Ansicht des zweiten erfindungsgemäßen Schaltungsträgers gemäß Fig. 7.

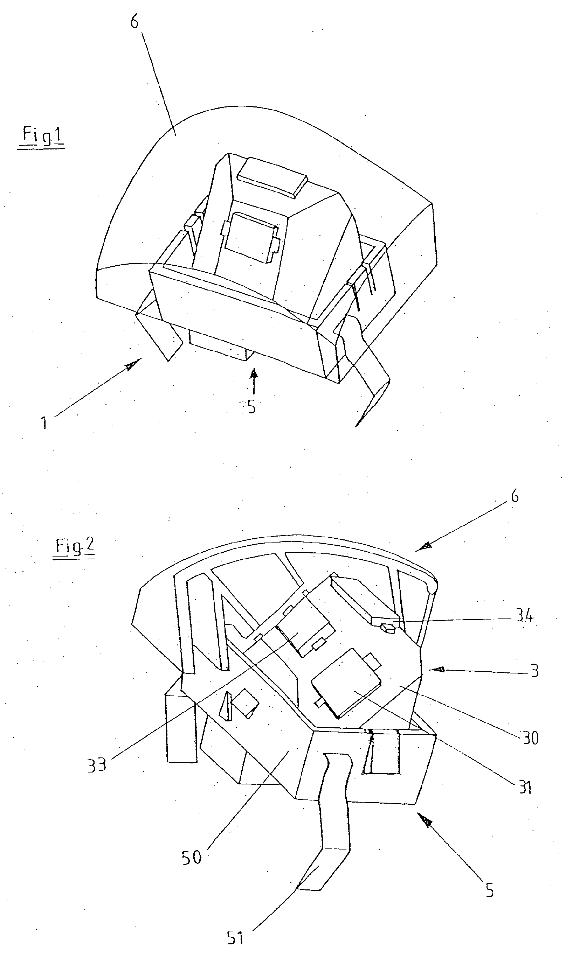

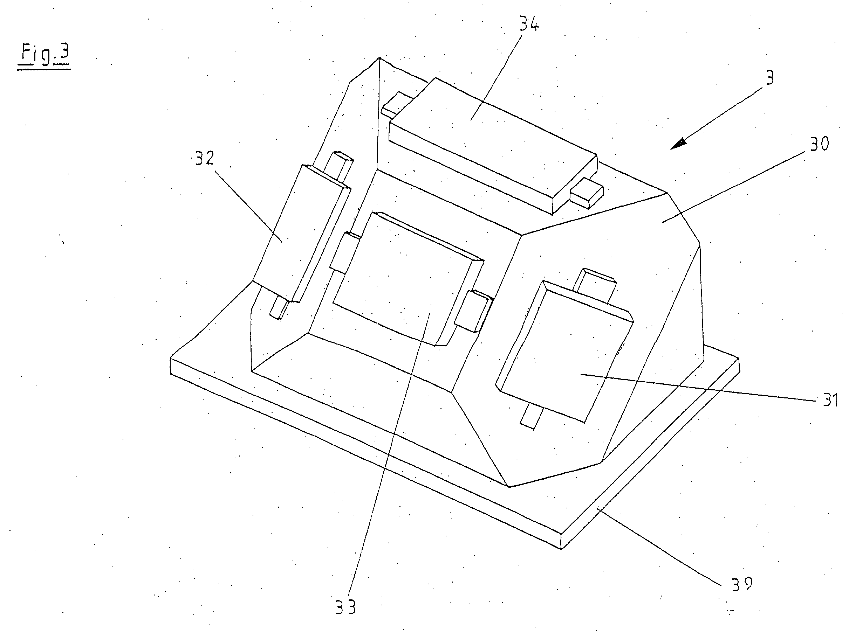

In den Fig. 1 und 2 sind jeweils perspektivische Ansichten der erfindungsgemäßen Sensorvorrichtung 1 dargestellt. Diese ist im wesentlichen aus drei Elementen, nämlich einem dreidimensionalen, spritzgegossenen Schaltungsträger 3, einem Untergehäuse 5 und einer Abdeckung 6 zusammengesetzt. Der spritzgegossene Schaltungsträger 3 ist dabei in einem kastenartigen Grundkörper 50 des Untergehäuses 5 aufgenommen, das wiederum Federbeine 51 aufweist, mit denen der spritzgegossene Schaltungsträger beispielsweise auf einem Armaturenbrett eines Kraftfahrzeuges angeordnet werden kann. Das Untergehäuse 5 ist zudem mit Rastelementen versehen, die mit korrespondierenden Rastelementen in der Abdeckung 6 zusammenwirken. In Fig. 1 ist eine Abdeckung 6 dargestellt, die aus einer homogenen Schicht ausgebildet ist, die einzig und allein eine schützende und lichtstreuende Aufgabe hat, so daß das durch die Abdeckung 6 eintretende Licht zuverlässig auf die darunter liegenden Photodetektoren 31, 32, und 33 fällt und zudem die Anzeige 34 der Diebstahlwarnanlage von außen erkennbar ist. Die einzelnen Elemente der Sensorvorrichtung 1 werden im folgenden unter Bezugnahme auf die Einzeldarstellungen in den Fig. 3 bis 6 weiter erläutert.

Fig. 3 zeigt eine erste perspektivische Ansicht, nämlich im wesentlichen eine Ansicht von oben, auf den spritzgegossenen Schaltungsträger 3 mit den darauf angeordneten IR-Photodetektoren 31 und 32 und dem Photodetektor 33 für sichtbares Licht. Die drei Photodetektoren sind als Photodioden ausgebildet, die auf dem spritzgegossenen dreidimensionalen Schaltungsträger angeordnet sind. Dabei ist jeder Photodetektor auf einer Ebene des spritzgegossenen Schaltungsträgers 3 angeordnet. Der spritzgegossene Schaltungsträger 3 weist insgesamt vier mit Funktionseinheiten belegte Flächen auf, die alle in verschiedene Winkel zueinander ausgerichtet sind. Parallel zur Grundebene 39 des spritzgegossenen Schaltungsträgers 3 und auch der Sensorvorrichtung 1 ist eine obere Ebene zur Aufnahme der Anzeige 34 der Diebstahlwarnanlage vorgesehen. Die Anzeige 34 für die Diebstahlwarnanlage ist gerade nach oben ausgerichtet. Diese Ebene ist trapezförmig ausgebildet und es schließen sich an die Schrägseiten zwei schräg nach vorne abfallende Ebenen an, auf denen die IR-Photodioden 31 und 32 angeordnet sind. Diese sind in Fahrtrichtung des Autos gesehen den Außenseiten zugewandt und sind nach vorne, innen zulaufend und gleichzeitig nach oben gekippt ausgerichtet. An der kurzen Parallelseite des Trapezes, auf dem die Anzeige 34 der Diebstahlwarnanlage angeordnet ist, ist eine im wesentlichen quadratische, im wesentlichen nach vorne, leicht nach oben ausgerichtete Fläche mit dem Photodetektor 33 für sichtbares Licht angeordnet. Dieser Photodetektor 33 dient zur Steuerung der Instrumentenbeleuchtung. An beide Seiten der Fläche mit dem Photodetektor 33 schließen sich wiederum die gegenüber dieser Fläche abgewinkelten Flächen mit den IR-Photodetektoren 31 und 32 an.

In Fig. 4 ist eine Untenansicht des spritzgegossenen Schaltungsträgers 3 dargestellt, wobei insbesondere die Grundebene 39 mit den darauf angeordneten elektrischen und/oder elektronischen Bauteilen 36 dargestellt ist. Die Flächen 30 des spritzgegossenen Schaltungsträgers 3 sind im wesentlichen aus einem thermoplastischen Material hergestellt, wobei darauf die elektrischen Anschlüsse für die Photodetektoren und die elektronischen

Bauteile 36 vorgesehen sind. Weiterhin sind vier Anschlußpins 37 zur Ansteuerung der Photodetektoren und der Anzeige 34 vorgesehen.

In Fig. 5 ist das Untergehäuse 5 dargestellt, das im wesentlichen einen kastenförmigen Grundkörper 50 aufweist, an dem nach unten zeigende Federn 51 angeordnet sind, mit denen die Sensorvorrichtung am Montageort befestigt wird. In den kastenförmigen Grundkörper 50 ist der spritzgegossene Schaltungsträger 3 mit seiner Grundebene 39 formschlüssig einsetzbar. Weiterhin sind im Außenbereich Rastelemente 53 und an der Oberseite Rastelemente 54 vorgesehen.

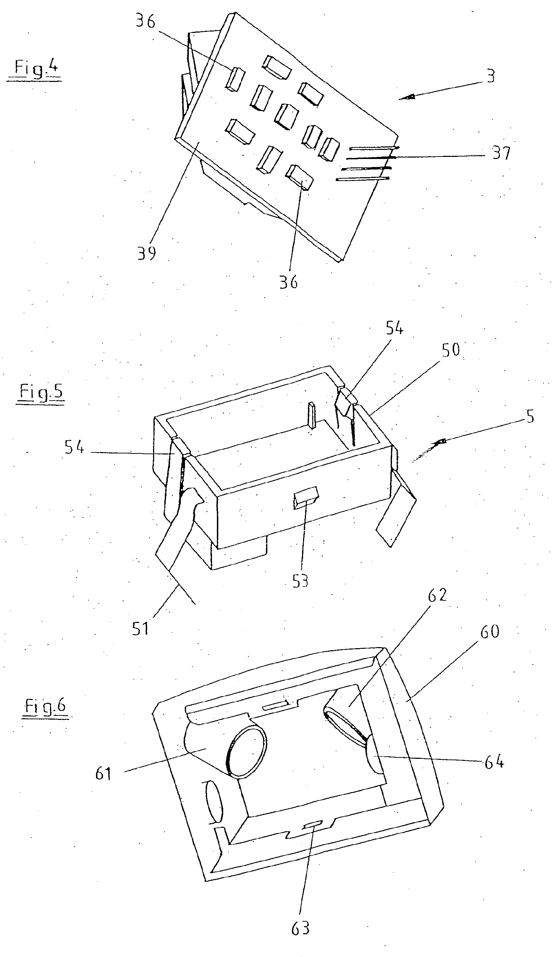

In Fig. 6 ist eine Untenansicht der Abdeckung 6 dargestellt, die im wesentlichen aus einem durchlässigen oder halbdurchlässigen Kunststoffmaterial 60 besteht. In diese in der Regel ebenfalls spritzgegossene Abdeckung 6 sind Rastelemente 63 und 64 integriert, die zu den Rastelementen 53 und 54 des Untergehäuses 5 korrespondieren. Zusätzlich zu der Darstellung der Abdeckung 6 in den Fig. 1 und 2 sind hier lichtleitende Elemente 61, 62 vorgesehen, die röhrenartig ausgebildet sind und eine verstärkte, richtungsabhängige Lichteinstrahlung auf die darunter angeordneten IR-Photodetektoren 31 und 32 ermöglichen.

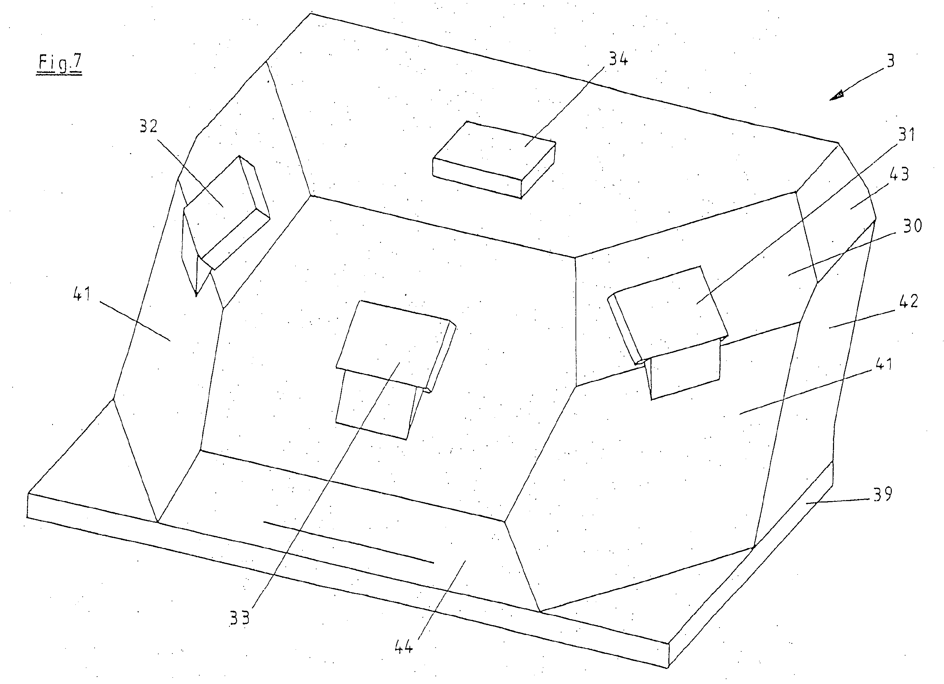

In Fig. 7 ist eine perspektivische Ansicht einer zweiten Ausführungsform eines erfindungsgemäßen Schaltungsträgers, vergleichbar zu Fig. 3, dargestellt. Der Schaltungsträger 3 weist ebenfalls die IR-Photodetektoren 31 und 32 und den Photodetektor 33 für sichtbares Licht auf. Der Schaltungsträger wird dabei so in ein Kraftfahrzeug eingesetzt, daß der Photodetektor 33 nach vorne ausgerichtet ist. Die Grundplatte 39 ist horizontal montiert, so daß der Photodetektor 33 über die untere Fläche 44 mit seiner Ebene schräg nach hinten gekippt ist, so daß der Photodetektor 33 leicht nach oben gekippt ist. Rechts und links an den Photodetektor 33 schließen sich die Flächen 30 mit den darauf montierten IR-Photodetektoren 31 und 32 an. Diese sind einerseits gegenüber der Fläche des Photodetektors 33 schräg nach hinten und oben gekippt. Dadurch wird eine besonders gute richtungsabhängige Detektierung der Sonneneinstrahlung möglich. Es erfolgt eine besonders genaue Richtcharakteristik. Durch die Gesamtausgestaltung des dreidimensionalen Schaltungsträgers 3 sind auch flexiblere Möglichkeiten in der Ausgestaltung der Richtcharakteristik gegeben. Es können auch mehrere Photodioden auf dem Grundkörper untergebracht werden, so daß dadurch die Variabilität der Möglichkeiten noch weiter erhöht wird. Auch diese Ausführungsform des Schaltungsträgers kann in Kombination mit einer bestimmten Filtercharakteristik der Abdeckung und gegebenenfalls des Photodetektors verwendet werden, wodurch eine wellenabhängige Erfassung und Auswertung des Sonnenlichtes ermöglicht wird.

Unterhalb der Fläche 30 mit dem IR-Photodetektor 31 ist eine gegenüber dieser Fläche 30 abgewinkelte Fläche 41 vorgesehen, die sich bis zur Grundplatte 39 erstreckt und auf dieser endet, wobei eine freie Ecke der Grundplatte 39 verbleibt. Die Fläche 41 grenzt an die vordere zentrale Fläche an, auf der der Photodetektor 33 angeordnet ist, und hat auch eine Berührungslinie mit der Fläche 44. Gegenüberliegend zu der Seite mit den Berührungsflächen zur zentralen Fläche und zur Fläche 44 schließt sich die zur Fläche 41 abgewinkelte Fläche 42 an, die sich im wesentlichen senkrecht von der Grundplatte 39 nach oben erstreckt. Diese Fläche 42 grenzt auch an die Fläche 30 in einem Eckbereich an. Nach oben grenzt an die Fläche 42 eine abgewinkelte Fläche 43, die einerseits an die dazu abgewinkelte Fläche 30 und andererseits an die dazu abgewinkelte horizontale obere Fläche angrenzt, auf der die Anzeige 34 angeordnet ist.

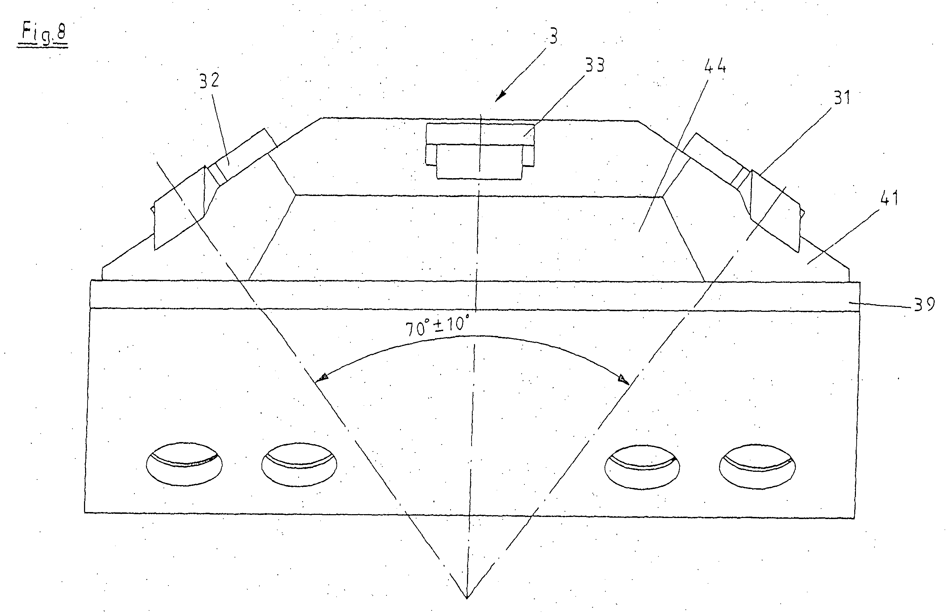

In Fig. 8 ist eine weitere perspektivische Ansicht des Schaltungsträgers 3 dargestellt, wobei der Schaltungsträger 3 im wesentlichen von unten, also von seiten der Grundebene 39 her, dargestellt ist. Als Linien sind Flächennormale durch die Flächen der IR-Photodetektoren 31 und 32 dargestellt. Diese Linien schneiden sich unter einem Winkel von 70°. Die Photodetektoren sind unter einem Winkel von 70° +/- 10° zueinander ausgerichtet, da auf diese Weise eine besonders gute Prüfung der Einstrahlcharakteristik der Sonne auch bei vergleichsweise niedrigem Sonnenstand erreicht wird.

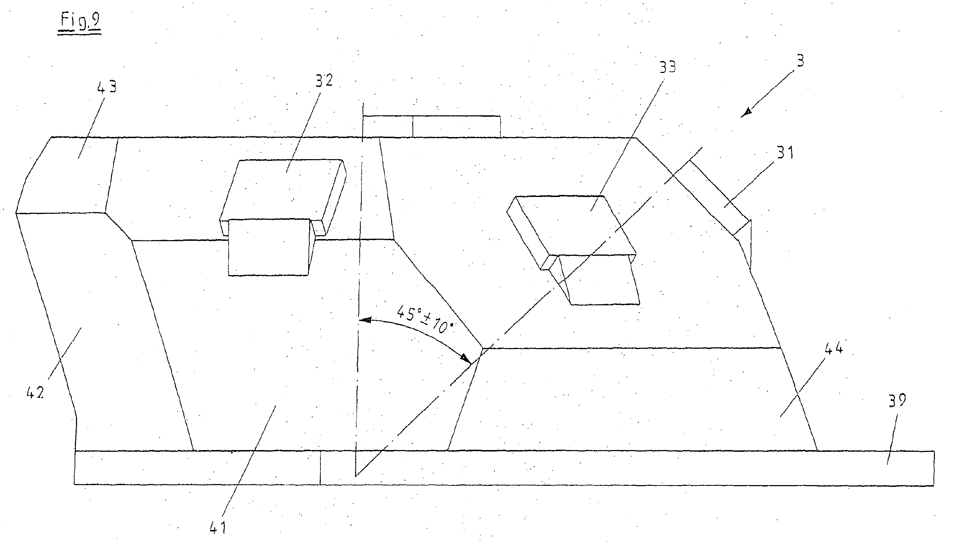

In Fig. 9 ist der dreidimensionale Schaltungsträger in einer solchen Ansicht dargestellt, daß die Fläche des IR-Photodetektors 31 senkrecht in der Zeichenebene steht, so daß mit der gestrichelten Linie eine Flächennormale zu dem IR-Photodetektor 31 dargestellt ist. Die Flächennormale des IR-Photodetektors 31 steht unter einem Winkel von 45° zur Senkrechten oder zum Lot des gesamten Schaltungsträgers 3. In alternativen Ausführungen beträgt dieser Winkel +/- 10°. Die Fläche des IR-Photodetektors 32 ist aufgrund des spiegelsymmetrischen Aufbaus des Schaltungsträgers 3 in gleicher Weise unter einem Winkel von 45° zum Lot oder auch zur Grundebene 39 ausgerichtet.

## Patentansprüche

1. Sensorvorrichtung zum Erzeugen eines elektrischen Ausgangssignals in Abhängigkeit von der Position einer Lichtquelle in Bezug auf die Sensorvorrichtung, wobei die Sensorvorrichtung einen dreidimensionalen Schaltungsträger (3) mit mehreren aneinandergrenzenden, in verschiedene Richtungen ausgerichteten Flächen aufweist, auf denen mindestens zwei Sensoren (31, 32) angeordnet sind,
**dadurch gekennzeichnet,**
**daß** zu beiden Seiten einer zentralen Fläche jeweils eine unter einem Winkel zu dieser Fläche ausgerichtete Fläche mit je einem IR-Photodetektor (31, 32) angeordnet ist, wobei die Flächen, auf denen die IR-Photodetektoren angeordnet sind, nicht unmittelbar aneinandergrenzen.

2. Sensorvorrichtung nach Anspruch 1, **dadurch gekennzeichnet, daß** auf der zentralen Fläche ein Photodetektor (33) als Photodetektor im Bereich des sichtbaren Lichtes angeordnet ist.

3. Sensorvorrichtung nach einem der Ansprüche 1 oder 2, **dadurch gekennzeichnet, daß** die Sensorvorrichtung (1) drei Sensoren, insbesondere Photodetektoren (31, 32, 33), aufweist, die in voneinander verschiedene Richtungen ausgerichtet sind.

4. Sensorvorrichtung nach einem der vorhergehenden Ansprüche, **dadurch gekennzeichnet, daß** die Photodetektoren (31, 32, 33) als Photodioden ausgebildet sind.

5. Sensorvorrichtung nach einem der vorhergehenden Ansprüche, **dadurch gekennzeichnet, daß** die Flächennormalen der Sensoren, insbesondere der IR-Photodetektoren (31, 32), sich unter einem Winkel zwischen 60° und 80°, insbesondere unter einem Winkel von 70°, schneiden.

6. Sensorvorrichtung nach einem der vorhergehenden Ansprüche, **dadurch gekennzeichnet, daß** die Flächennormalen der IR-Photodetektoren (31, 32) und eine Grundebene (39) der Sensorvorrichtung (1) in beiden Dimensionen von 90° abweichende Schnittwinkel haben.

7. Sensorvorrichtung nach einem der vorhergehenden Ansprüche, **dadurch gekennzeichnet, daß** die Flächennormalen der IR-Photodetektoren und eine Grundebene der Sensorvorrichtung sich unter einem Winkel zwischen 35° und 55°, insbesondere unter einem Winkel von 45°, schneiden

8. Sensorvorrichtung nach einem der vorhergehenden Ansprüche, **dadurch gekennzeichnet, daß** die IR-Photodetektoren (31, 32) symmetrisch zu dem zentral angeordneten Photodetektor (33) für sichtbares Licht angeordnet sind.

9. Sensorvorrichtung nach einem der vorhergehenden Ansprüche, **dadurch gekennzeichnet, daß** in die Sensorvorrichtung (1) eine Anzeige (34) für eine Diebstahlwarnanlage integriert ist.

10. Sensorvorrichtung nach Anspruch 9, **dadurch gekennzeichnet, daß** die Anzeige (34) für die Diebstahlwarnanlage parallel zu einer Grundebene (39) der Sensorvorrichtung (1) ausgerichtet ist.

11. Sensorvorrichtung nach einem der vorhergehenden Ansprüche, **dadurch gekennzeichnet, daß** die Sensorvorrichtung (1) eine die Sensoren abdeckende lichtdurchlässige Abdeckung (6) aufweist.

12. Sensorvorrichtung nach Anspruch 11, **dadurch gekennzeichnet, daß** die Abdeckung (6) optische Elemente (61, 62) aufweist.

13. Sensorvorrichtung nach Anspruch 12, **dadurch gekennzeichnet, daß** die optischen Elemente (61, 62) als auf die IR-Photodetektoren (31, 32) gerichtete lichtleitende Elemente ausgebildet sind.

14. Sensorvorrichtung nach Anspruch 13, **dadurch gekennzeichnet, daß** die lichtleitenden Elemente (61, 62) senkrecht auf die Photodetektoren (31, 32) ausgerichtet sind.
